Europäisches Patentamt

European Patent Office

Office européen des brevets

(11) Publication number: **0 228 295 B1**

(12) **EUROPEAN PATENT SPECIFICATION**

(45) Date of publication of patent specification: **26.08.92**

(51) Int. Cl.⁵: **H01L  31/18,** H01L 31/08, H01L 29/78, H01L 21/205, C23C 16/48

(21) Application number: **86310163.0**

(22) Date of filing: **24.12.86**

(54) **Method for producing an electronic device having a multi-layer structure.**

(30) Priority: **28.12.85 JP 298044/85**

(43) Date of publication of application:
**08.07.87 Bulletin  87/28**

(45) Publication of the grant of the patent:
**26.08.92 Bulletin  92/35**

(84) Designated Contracting States:
**DE FR GB IT NL**

(56) References cited:
**EP-A- 0 231 660**
**DE-A- 3 429 899**
**GB-A- 2 083 705**

**JAPANESE JOURNAL OF APPLIED PHYSICS, vol. 24, no. 8, August 1985, part 1, pages 997-1002, Tokyo, JP; J. KENNE et al.: "Amorphous-silicon solar cells prepared by a combined photochemical-plasma CVD technique"**

(73) Proprietor: **CANON KABUSHIKI KAISHA**
**30-2, 3-chome, Shimomaruko, Ohta-ku**
**Tokyo(JP)**

(72) Inventor: **Ohtoshi, Hirokazu**
**636-710, Marukodori 1-chome Nakahara-ku**
**Kawasaki-shi Kanagawa-ken(JP)**
Inventor: **Hanna, Jun-ichi**
**5780, Nagatsuta-cho, Midori-ku**
**Yokohama-shi Kanagawa-ken(JP)**
Inventor: **Shimizu, Isamu**
**20-3-501, Edaminami 5-chome Midori-ku**
**Yokohama-shi Kanagawa-ken(JP)**

(74) Representative: **Beresford, Keith Denis Lewis et al**
**BERESFORD & Co. 2-5 Warwick Court High Holborn**
**London WC1R 5DJ(GB)**

APPLIED PHYSICS LETTERS, vol. 43, no. 8, October 1983, pages 774-776, American Institute of Physics, New York, US; T. INOUE et al.: "Photochemical vapor deposition of undoped and n-type amorphous silicon films produced from disilane"

APPLIED PHYSICS LETTERS, vol. 45, no. 8, October 1984, pages 865-867, American Institute of Physics, New York, US; T. TANAKA et al.: "Amorphous silicon solar cells fabricated by photochemical vapor deposition"

JAPANESE JOURNAL OF APPLIED PHYSICS, vol. 22, no. 1, January 1983, part 2, pages L46-L48, Tokyo, JP; Y. MISHIMA et al.: "Silicon thin-film formation by direct photochemical decomposition of disilane"

JOURNAL OF APPLIED PHYSICS, vol. 58, no. 9, November 1985, pages 3664-3666, American Institute of Physics, Woodbury, New York, US; H. TAKEI et al.: "High-energy conversion efficiency amorphous silicon solar cells by photochemical vapor deposition"

JAPANESE JOURNAL OF APPLIED PHYSICS. SUPPLEMENTS, PROCEEDINGS OF THE 14TH CONFERENCE ON SOLID STATE DEVICES, Tokyo, 1982, vol. 22, no. 22-1, 1983, pages 617-618, Tokyo, JP; T. SAITOH et al.: "Novel amorphous silicon solar cells prepared by photochemical vapor deposition"

## Description

BACKGROUND OF THE INVENTION

Field of the Invention

This invention relates to a multi-layer structure which can be used to form an electronic device such as thin film semiconductor device, photovoltaic device, image forming member for electrophotography, etc., and a method for producing the same.

In the prior art, functional films, i.e., semiconductor thin films for electronic devices such as thin film semiconductor devices, imaging devices, etc., particularly amorphous or polycrystalline semiconductor films, are formed individually by film forming methods chosen according to desired physical characteristics, uses, etc. of the film.

Various methods have been attempted for formation of a silicon-deposited film (amorphous or polycrystalline, i.e., non-single crystalline), or for silicon film which is optionally compensated for lone pair electrons with a compensating agent such as hydrogen atoms (H) or halogen atoms (X), etc., (generally "NON-Si (H,X)", or "A-Si (N,X)" for amorphous and microcrystalline silicon, and "poly-Si (H,X)" for polycrystalline silicon). These methods include vacuum vapor deposition, plasma CVD (PCVD), thermal CVD, reactive sputtering, ion plating, optical CVD, etc. Typical optical CVD deposition is described in Applied Physics Letters, Vol. 45, No 8, pages 865 - 867 (1984) and Japanese Journal of Applied Physics, Vol. 22, No.1, Part 2, pages L46 - L48, (1983). Generally, plasma CVD has been widely used industrially. One plasma CVD method is described in DE-A-3 429 899

However, the prior art reaction process for plasma CVD formation of a silicon-deposited film is more complicated than the CVD method of the prior art, and its reaction mechanism is not clear. Also, there are a large number of parameters for formation of a deposited film (for example, substrate temperature, flow rates and flow rate ratio of introduced gases, pressure during formation, high frequency power, electrode structure, structure of reaction vessel, evacuation rate, plasma generating system, etc.). Because of the dependency on such a large number of parameters, formed plasma may sometimes become unstable, which often leads to marked deleterious effects on the deposited film formed. Besides, such parameters characteristic of each apparatus must be selected individually. Therefore under the present situation, it is difficult to standarize the production conditions.

On the other hand, for a silicon deposited film to exhibit sufficiently satisfactory electrical or optical characteristics for respective uses, it is now accepted that the best way to form is by plasma CVD.

However, depending on the intended use of a silicon-deposited film, reproducible production in bulk may be required, whilst ensuring enlargement of area, uniformity of film thickness as well as uniformity of film quality. Therefore for formation of silicon-deposited film by plasma CVD, enormous investment is required for bulk production apparatus. Also controls for such bulk production are complicated, since control tolerances are narrow. These problems are pointed out as requiring improvement in the future.

Also, since plasma for plasma CVD is directly generated (by high frequency, microwave, etc.) in a space where film formation is to occur, electrons or ion species may damage the film being formed causing lowering of film quality or non-uniform film quality.

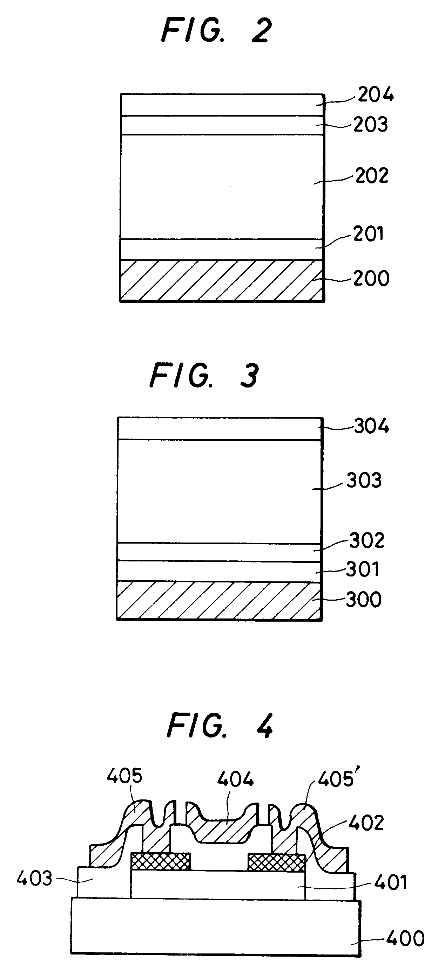

Particularly, in the case of producing an electronic device having a multi-layer structure, interface defects formed between the respective layers may cause worsening of the characteristics of the electronic device obtained. There is shown in Fig. 4 an image forming member for electrophotography as an example. There is found a layer constitution, on a substrate 400 made of aluminum, consisting of a charge injection preventing layer (first layer, amorphous silicon layer doped with boron B) 401, a photosensitive layer (second layer, amorphous layer not doped with impurities such as B) 402 and a surface protective layer (third layer, amorphous silicon carbide layer) 403 respectively deposited. If all the layers are to be formed by the PCVD method, since the kinds of starting material gases, flow rates and plasma discharging intensity for formation of the respective deposited layers differ extremely from one another, efforts will be required to decrease the influence of the interfaces formed between the respective deposited layers ordinarily by stopping discharging between the steps for formation of the first layer and the second layer or for formation of the second layer and the third layer to exchange completely gases, or if continuous production is to be employed by providing a varied layer by varying gradually the kinds of gases, flow rates and plasma discharging intensity, or by providing deposition chambers for formation of the respective deposited layers separately. In any case, ions generated in the plasma are collided against a layer formed to increase defects. Particularly, in producing an electronic device having multi-layer constitution, influence of ion collision in the plasma is noticeably severe on the interfaces of respective layers. For this reason, satisfactory improvement therein is required.

As described above, in formation of silicon series deposited film, points to be solved still remain, and it has been earnestly desired to develop a method for forming a deposited film which is capable of bulk production with conservation of energy by the use of an apparatus of low cost, while maintaining the characteristics as well as uniformity of the film at a practically applicable level. Particularly, it has been earnestly desired to improve the interface characteristics of an electronic device having a multi-layer structure such as thin film transistor, photovoltaic device, photosensitive member for electrophotography, etc.

## SUMMARY OF THE INVENTION

An object of the present invention is to remove such drawbacks of a method for forming a deposited film as described above and at the same time to provide a novel method for producing a multi-layer structure without the use of the formation method of the prior art.

Another object of the present invention is to provide a method for forming a deposited film capable of obtaining a deposited film with improved interface characteristics over a large area with easy control of film quality and conservation of energy.

Still another object of the present invention is to provide a method for producing a multi-layer structure which is excellent in productivity and bulk productivity, having high quality as well as excellent physical characteristics such as electrical, optical and semiconductor characteristics.

According to the present invention, there is provided a method for producing a multi-layer structure comprising two or more semiconductor layers one at least of which is a thin layer controlled in band gap, formed on a substrate, which comprises:

a) forming at least one of said semiconductor thin layers controlled in band gap according to optical CVD by bringing together a gaseous starting material and a material for controlling band gap; and

b) forming at least one of the other constituent layers, optionally controlled in band gap, according to a method comprising:

i) introducing a gaseous starting material for formation of a deposited film and a gaseous halogenic oxidizing agent having the property of oxidizing said starting material into a reaction space to effect chemical contact therebetween to thereby form a plural number of precursors containing a precursor under excited state; and

ii) transferring at least one precursor of those precursors into a film forming space communicated with the reaction space as a feeding source for the constituent element of the deposited film.

According to the method of the present invention, a multi-layer structure improved in interface characteristics is obtained, and simplification of control and bulk production can be effected whilst ensuring enlargement of area, uniformity of film thickness and uniformity of film quality simultaneously with conservation of energy. This can be done without enormous installation investment for bulk production apparatus. Also controls for bulk production are simplified allowing broad tolerances.

## BRIEF DESCRIPTION OF THE DRAWINGS

Fig. 1 is a schematic illustration of an apparatus for forming a deposition film for practicing the method of the present invention.

Fig. 2 is a schematic illustration of layers of a solar cell produced by the method of the present invention.

Fig. 3 is a schematic illustration of layers of an image forming member for electrophotography produced by the method of the present invention.

Fig. 4 is a schematic illustration of layers of a thin film transistor produced by the method of the present invention.

Fig. 5 is a schematic illustration of an apparatus for forming a deposition film by optical CVD.

## DESCRIPTION OF THE PREFERRED EMBODIMENT

In the method for producing a multi-layer structure of the present invention, gaseous starting material to be used for formation of a deposited film (semiconductor thin film by the FOCVD method) is to be oxidized by chemical contact with a gaseous halogenic oxidizing agent. The oxidizing agent can be selected according to the kind of film desired, and according to its intended use.

In the present invention, the above gaseous starting material and the gaseous halogenic oxidizing agent

4

need be made gaseous only during chemical contact when introduced into a reaction space.

They can therefore be liquid or solid in their ordinary state. When the starting material for formation of a deposited film or the halogenic oxidizing agent is liquid or solid, it is introduced in gaseous state into the reaction space through performing bubbling with the use of a carrier gas such as Ar, He, $N_2$, $H_2$, etc. optionally with application of heat.

During this operation, the partial pressures and mixing ratio of the above gaseous starting material and the gaseous halogenic oxidizing agent may be set by controlling the flow rate of the carrier gas and the vapor pressures of the starting material for formation of a deposited film and the gaseous halogenic oxidizing agent.

The starting material for formation of a deposited film to be used in the FOCVD method of the present invention may be as follows. If a group IV A element-containing deposited film such as semiconductive or electrically insulating silicon deposited film or germanium deposited film, etc., is desired to be obtained, straight or branched chain silane compounds, cyclic silane compounds, chain germanium compounds, etc., may be employed as the starting material. Specifically, examples of straight chain silane compounds may include $Si_nH_{2n+2}$ (n = 1, 2, 3, 4, 5, 6, 7, 8), examples of branched chain silane compounds include $SiH_3SiH$-($SiH_3$) $SiH_2SiH_3$ and examples of cyclic silane compounds include $Si_nH_{2n}$ (n = 3, 4, 5, 6).

One or more of these starting materials may be used; and they may also be used as the starting material gas for the optical CVD method.

The halogenic oxidizing agent to be used in the present invention is to be made gaseous when introduced into the reaction space. It then has the property of effectively oxidizing the gaseous starting material by mere chemical contact therewith. The halogenic oxidizing agent may be a halogen gas such as $F_2$, $Cl_2$, $Br_2$, $I_2$, etc., and fluorine, chlorine, bromine, etc., under nascent state.

The halogenic oxidizing agent is introduced into the reaction space under gaseous state together with the gas of the starting material for formation of a deposited film. This is done with desired flow rate and feeding pressure. The oxidizing agent mixes with and collides against the starting material which it contacts. This oxidizes the starting material, and generates efficiently a plurality of precursors which contain a precursor in chemically excited state. At least one of the precursors functions as a feeding source for the constituent element of the film to be deposited.

The precursors generated may undergo decomposition or reaction to be converted to other excited precursors, or to the same precursors but to other excited states, or alternatively may be left in their original form. Nonetheless, if desired, the precursors may release energy and contact a surface of the substrate in the film forming space, thus forming a deposited film with a three-dimensional network structure. This may happen when the substrate surface temperature is relatively low, or a crystalline deposited film may be formed when the substrate surface temperature is higher.

In the present invention, various parameters may be selected so that film deposition proceeds smoothly to form a film of high quality having the desired physical characteristics. These parameters include the kinds and combinations of the starting material, the halogenic oxidizing agent, the mixing ratio between them, pressure during mixing, flow rate, pressure within the film forming space, gas flow velocity, and film forming temperature (substrate temperature and atmosphere temperature). These parameters are mutually related and are not therefore to be determined individually. In the present invention, the ratio of flow rates into the reaction space of gaseous starting material to gaseous halogenic oxidizing agent will depend on the various parameters mentioned above, but it is preferably from 1/20 to 100/1, more preferably from 1/5 to 50/1.

The pressure during mixing when introduced into the reaction space may be preferably higher in order to enhance the probability of chemical contact between the above gaseous starting material and the above gaseous halogenic oxidizing agent, but it is better to determine the optimum value suitably as desired in view of reactivity. Although the pressure during mixing may be determined as described above, each pressure during introduction may be preferably $1 \times 10^{-2}$ to $5 \times 10^5$ Pa, more preferably $1 \times 10^{-1}$ to $2 \times 10^5$ Pa (preferably $1 \times 10^{-7}$ atm to 5 atm, more preferably $1 \times 10^{-6}$ atm to 2 atm).

The pressure within the film forming space, namely the pressure of the space in which a substrate for film formation thereon is placed, may be set suitably as desired so that precursors (E) under excited state generated in the reaction space and sometimes precursors (D) formed as secondary products from said precursors (E) may contribute effectively to film formation.

When the film forming space is in open communication with the reaction space, the inner pressure of the film forming space, can be controlled with respect to the pressures and flow rates into the reaction space of the starting materialand oxidizing agent. This can be done, for example, by application of a contrivance such as differential evacuation or use of a large scale evacuating device.

Alternatively, when the conductance at the communicating portion between the reaction space and the film forming space is small, the pressure in the film forming space can be controlled by providing an appropriate evacuating device to the film forming space and controlling the evacuation rate of said device.

On the other hand, when the reaction space and the film forming space is integrally made and the reaction position and the film forming position are only different in space, it is possible to effect differential evacuation or provide a large scale evacuating device having sufficient evacuating capacity as described above.

As described above, the pressure in the film forming space may be determined by the introduction pressures of the starting material and the halogenic oxidizing agent introduced into the reaction space, but is is preferably 0.13 - 1.3 x $10^4$ Pa, more preferably 1.3 - 4 x $10^3$ Pa, optionally 6.67 - 1.3 x $10^3$ Pa (preferably 0.001 Torr to 100 Torr, more preferably 0.01 Torr to 30 Torr, optimally 0.05 to 10 Torr).

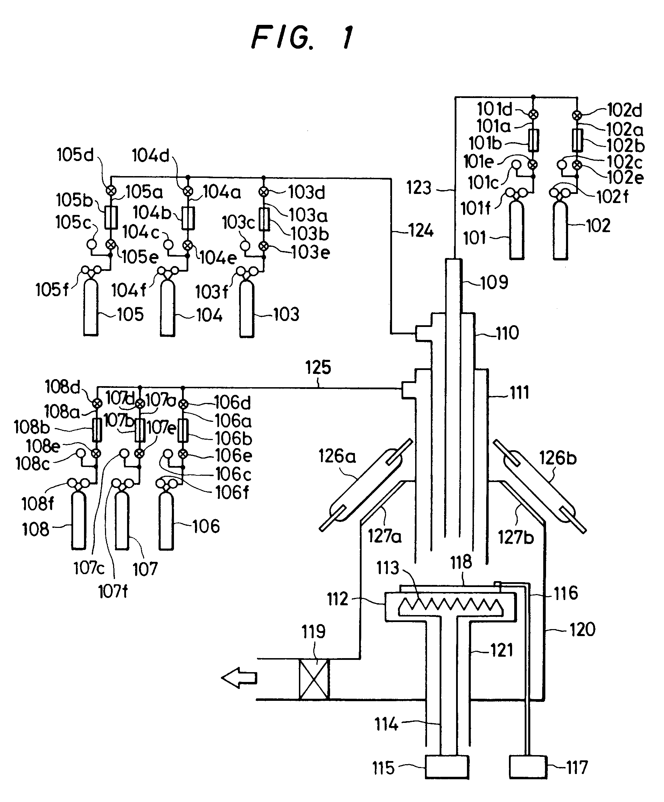

The gas flow velocity is to be chosen in view of the geometric arrangement of a gas introducing port, the substrate and a gas discharging port. The aim is that the starting material and the halogenic oxidizing agent may be efficiently mixed during their introduction into the reaction space, the above precursors (E) may be efficiently generated, and film formation may be adequately performed without trouble. A preferred example of the geometric arrangement is shown in Fig. 1.

The substrate temperature (Ts) during film formation is to be set as desired, depending on the gas species employed and the kinds and required characteristics of the film to be deposited. Nonetheless, if an amorphous film is to be formed, that temperature is preferably from room temperature to 450°C, more preferably from 50 to 400°C. Particularly, in the case of forming a silicon deposited film with better semiconductor characteristics and photoconductive characteristics, etc., the substrate temperature (Ts) should desirably be made 70 to 350°C. On the other hand, in the case of obtaining a polycrystalline film, it should preferably be 200 to 700°C, more preferably 300 to 600°C.

The atmosphere temperature (Tat) in the film forming space is to be determined in conjunction with the substrate temperature so that precursors (E) may be efficiently generated, and so that they and precursors (D) are not changed to chemical species unsuitable for film formation.

Fig. 1 shows an example of preferred apparatus for forming a deposited structure of the present invention.

The deposited film forming apparatus shown in Fig. 1 is broadly divided into a main body (vacuum chamber), an evacuation system and a gas feeding system.

In the mainbody, a reaction space and a film forming space are provided.

101-108 are respectively bombs filled with the gases to be used during film formation, 101a-108a are respectively gas feeding pipes, 101b-108b are respectively mass flow controllers for controlling the flow rates of the gases from the respective bombs, 101c-108c are respectively gas pressure gauges, 101d-108d and 101e-108e are respectively valves, and 101f-108f are respectively pressure gauges indicating the pressures in the corresponding gas bombs.

120 is a vacuum chamber equipped at the upper portion with a means for gas introduction, having a structure for formation of a reaction space downstream of the means, and also having a structure for constituting a film forming space in which a substrate holder 112 is provided so that a substrate 118 may be placed as opposed to the gas introducing port of said means. The means for gas introduction has a triple concentric tubular structure, having from the innerside a first gas introducing pipe 109 for introducing gases from the gas bombs 101, 102, a second gas introducing pipe 110 for introducing gases from the gas bombs 103-105, and a third gas introducing pipe 111 for introducing gases from the gas bombs 106-108.

For gas introduction to the reaction space from each gas introducing pipe, each position is designed so as to be arranged farther from the substrate surface as the pipe is nearer to the inner side. In other words, the gas introducing pipes are arranged so that the pipe on the outer side may enclose the pipe existing within the innerside thereof.

The gases from the respective bombs are fed into the respective introducing pipes through the gas feeding pipelines 123-125, respectively.

The respective gas introducing pipes, the respective gas feeding pipelines and the vacuum chamber 120 are evacuated to vacuum through a main vacuum valve 119 by means of an evacuating device not shown.

The substrate 118 is set at a suitable desired distance from the positions of the respective gas introducing pipes by moving vertically the substrate holder 112.

In the case of the present invention, the distance between the substrate and the gas introducing port of the gas introducing means may be determined appropriately in view of the kinds and desired characteristics of the deposited film to be formed, the gas flow rates, the inner pressure of the vacuum chamber, etc., but it is preferably several mm to 20 cm, more preferably 5 mm to about 15 cm.

113 is a heater for heating the substrate which is provided in order to heat the substrate to an appropriate temperature during film formation, or preheating the substrate 118 before film formation, or further to anneal the film after film formation.

The substrate heating heater 113 is supplied with power through a conductive wire 114 from a power source 115.

116 is a thermocouple for measuring the temperature of the substrate (Ts) and is electrically connected to the temperature display device 117.

126a and 126b are light energy generating devices for supplying light energy into the vacuum chamber 120. 127a and 127b are windows for irradiating light energy into the vacuum chamber 120.

The gaseous material for supplying compounds containing elements for expanding band gap as the band gap controller to be used in the present invention may include carbon containing compounds, oxygen compounds, nitrogen compounds, etc.

Specifically, examples of carbon containing compounds may include compounds represented by the formula $C_nH_{2n+2}$ (n is a natural number) such as $CH_4$, $C_2H_6$, $C_3H_8$, $C_4H_{10}$, etc., compounds represented by $C_nH_{2n}$ (n is a natural number) such as $C_2H_4$, $C_3H_6$, $C_4H_8$, etc., compounds such as $C_2H_2$, $C_6H_6$, etc. Examples of oxygen containing compounds may include compounds such as $O_2$, $CO_2$, $NO$, $NO_2$, $N_2O$, $O_3$, $CO$, $H_2O$, $CH_3OH$, $CH_3CH_2OH$, etc.

Examples of nitrogen containing compounds may include $N_2$, $NH_3$, $N_2H_5N_3$, $N_2H_4$, $NH_4N_3$, etc.

On the other hand, the gaseous material for supplying compounds containing elements for reducing band gap as the band gap controller may include chain germanium compounds, tin compounds, etc. as effective ones.

Specifically, examples of chain germanium compounds may include $Ge_mH_{2m+2}$ (m = 1, 2, 3, 4, 5), etc. and examples of tin compounds may include hydrogenated tin such as $SnH_4$, etc.

In the present invention, the method for forming a deposited film controlled in band gap is essentially different from that for formation of a deposited film uncontrolled in band gap. Nonetheless, both of the deposited film forming means can be arranged in the same apparatus for forming a deposited film. In this case, when either one of the deposited film forming means is working, the other deposited film forming means is required to be stopped. Also, it is possible to connect both of the deposited film forming means to each other through a gate valve, etc. and carry out formation of both of the deposited films continuously.

The valence electron controller, to be used when forming a deposited silicon or germanium semiconductor film layer controlled in valence electron, may include a p-type valence electron controller, namely compounds containing elements of the group III of the periodic table functioning as the so-called p-type impurity such as B, Al, Ga, In, Tl, etc., and n-type valence electron controller, namely compounds containing elements of the group V of the periodic table functioning as the so-called n-type impurity such as N, P, As, Sb, Bi, etc.

Specifically, the material for supplying the valence electron controller may include $NH_3$, $HN_3$, $N_2H_5N_3$, $N_2H_4$, $NH_4N_3$, $PH_3$, $P_2H_4$, $AsH_3$, $SbH_3$, $BiH_3$, $B_2H_6$, $B_4H_{10}$, $B_5H_9$, $B_5H_{11}$, $B_6H_{10}$, $B_6H_{12}$, $Al(CH_3)_3$, $Al(C_2H_5)_3$, $Ga(CH_3)_3$, $In(CH_3)_3$, etc. as effective ones.

These valence electron controllers can be used also as the band gap controller by adding them in large amounts.

The substrate to be used in the present invention may be either electroconductive or electrically insulating, provided that it is selected as desired depending on the use of the deposited film formed. As an electroconductive substrate, there may be mentioned metals such as NiCr, stainless steel, Al, Cr, Mo, Au, Ir, Nb, Ta, V, Ti, Pt, Pd, etc., or alloys thereof.

As an insulating substrate, there may be conventionally be used films or sheets of synthetic resins, including polyesters, polyethylene, polycarbonate, cellulose acetate, polypropylene, polyvinyl chloride, polyvinylidene chloride, polystyrene, polyamides, etc., glass, ceramics and so on. At least one side surface of these substrates is preferably subjected to treatment for imparting electroconductivity, and it is desirable to provide other layers on the side at which said electroconductive treatment has been applied.

For example, electroconductive treatment of a glass substrate can be effected by providing a thin film of NiCr, Al, Cr, Mo, Au, Ir, Nb, Ta, V, Ti, Pt, Pd, $In_2O_3$, $SnO_2$, ITO ($In_2O_3$ + $SnO_2$) thereon. Alternatively, a synthetic resin film such as polyester film can be subjected to the electroconductive treatment on its surface by vacuum vapor deposition, electron-beam deposition or sputtering of a metal such as NiCr, Al, Ag, Pb, Zn, Ni, Au, Cr, Mo, Ir, Nb, Ta, V, Ti, Pt, etc., or by laiminating treatment with such metals, thereby imparting electroconductivity to the surface. The substrate may be shaped in any form such as cylinders, belts, plates or others, and its form may be determined as desired.

The substrate should be preferably selected from among those set forth above in view of adhesion and reactivity between the substrate and the film. Further, if the difference in thermal expansion between both is great, a large amount of strains may be created within the film to give sometimes no film of good quality, and therefore it is preferable to use a substrate so that the difference in thermal expansion between both is small.

Also, the surface state of the substrate is directly related to the structure of the film (orientation) or generation of or a stylet structures, and therefore it is desirable to treat the surface of the substrate to give a film structure and a film texture so that desired characteristics may be obtained.

The layer to be formed by the optical CVD method is preferably formed by the use of such an apparatus as is adapted for utilization of both the FOCVD method and the optical CVD method as shown in Fig. 1. However, it may be formed by the use of a conventional optical CVD apparatus.

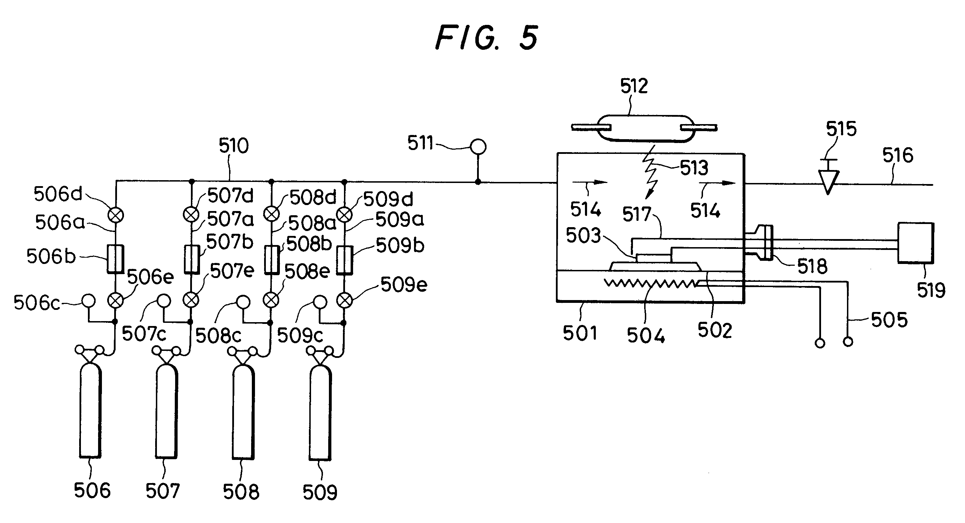

Fig. 5 illustrates schematically the device for forming a deposited film according to the optical CVD method.

501 is a deposition chamber for forming a deposited film, and 502 is a supporting stand for supporting a substrate 503 placed internally of the deposition chamber.

504 is a heater for heating the substrate and supplied with power through a conductive wire 505 to generate heat.

506 through 509 are gas feeding sources and they are provided corresponding to the kinds of gases including silicon containing compounds, hydrogen halogen compounds, inert gases and compounds containing as a component an impurity element for band gap controll. Of these starting material compounds, when those which are liquid under standard state are used, a suitable gasifying device is provided. In the drawing, the numerals of gas feeding sources 506 through 509 affixed with the symbol a are branched pipes, those affixed with b flowmeters, those affixed with c pressure gauges for measuring the pressues on the higher pressure side of the respective flowmeters, those affixed with d or e valves for controlling the respective gas flow rates. The gases of the starting material compounds are introduced through the introducing pipe 510 into the film forming chamber 501.

512 is a light energy generating device, and the light energy from the light energy generating device 511 acts on the starting material gas flowing in the direction of the arrowhead 514 to excite and decompose the starting material gas to form a deposited film controlled in band gap on the substrate 503 through the chemical reaction of the decomposed compounds. 515 is an evacuation valve, and 516 is an evacuation pipe, which is connected to an evacuation device (not shown) for vacuum evacuation internally of the film forming space.

The high energy light to be used in the method of the present invention may be one generated from, for example, low pressure mercury lamp, xenon lamp, carbon dioxide laser, argon ion laser, excimer laser, etc. as the generation source. The light energy to be used in the present invention is not limited to UV-ray energy, i.e. its wavelength is not limited, provided that it can excite, decompose and polymerize the starting material gas to deposit decomposed products. Also, the case when light energy is absorbed into the starting material gas or the substrate to be converted to heat energy and excitation or decomposition or polymerization of the starting material gas is brought about by the heat energy to form a deposited film is not also excluded.

When, for example, a deposited film controlled in band gap by a band gap controller is to be formed by use of such an apparatus, a suitable substrate is placed on the supporting stand and the film forming chamber is internally evacuated to be brought to reduced pressure through the evacuation pipe by use of an evacuation device (not shown).

Next, with heating of the substrate, if desired, starting material gases such as $SiH_4$, $H_2$, etc. and the starting material gases for band gap controller such as $O_2$, $GeH_4$, $CH_4$, etc. are introduced from the gas feeding bombs through the gas introducing pipe 510 into the film forming chamber 501, and plasma is generated in the film forming chamber by the plasma generating device with the pressure in the film forming space being maintained at a predetermined pressure to form a deposited film controlled in bad gap on the substrate 503.

Now, the production of a solar battery, a photosensitive device for electrophotography and a thin film transistor (hereinafter called TFT) according to the present invention is described in detail below.

Example 1

Fig. 2 illustrates schematically an example of the solar battery produced according to the present invention.

In this figure, on a glass substrate 200 are formed as a laminate a transparent electrode (not shown), p-type amorphous silicon carbide layer 201 (first layer, thickness 30 nm, 300 Å), i-type amorphous silicon layer 202 (second layer, thickness 1 $\mu$m) n-type amorphous silicon layer 203 (third layer, thickness 20 nm, 200 Å) and an Al electrode 204.

In depositing the p-type amorphous silicon carbide layer 201, $SiH_4$ gas in the bomb 101 was introduced at a flow rate of 20 sccm through the gas introducing pipe 109, $B_2H_6$/He gas ($B_2H_6$ concentration 10000ppm) in the bomb 103 at a flow rate of 3 sccm and $CH_4$ gas in the bomb 105 at a flow rate of 100 sccm through the gas introducing pipe 110 and He gas in the bomb 107 at a flow rate of 20 sccm through the gas introducing pipe 111 respectively into the vacuum chamber 120. From the low pressure mercury lamps 126a and 126b, light of 15 mW/cm$^2$ was irradiated. Thus, a p-type amorphous silicon carbide layer 201 expanded in band gap by carbon was formed. For this reason, the window effect was enhanced to improve photoelectric converting efficiency.

The i-type amorphous silicon layer 202 and the n-type amorphous silicon layer 203 were deposited by mixing and reacting a gaseous starting material for formation of deposited film and a gaseous halogenic oxidizing agent having the property of oxidative action for said starting material in the vacuum chamber 120 (by FOCVD).

That is, in the case of the i-type amorphous silicon 202, $SiH_4$ gas filled in the bomb 101 was introduced at a flow rate of 30 sccm through the gas introducing pipe 109, $F_2$ gas filled in the bomb 106 at a flow rate of 20 sccm and He gas filled in the bomb 107 at a flow rate of 100 sccm through the gas introducing pipe 111 into the vacuum chamber 120.

During this operation, the pressure in the vacuum chamber 120 was maintained at 93.3 Pa (0.7 Torr) by controlling the opening of the vacuum valve 119. The distance between the gas introducing pipe 111 and the substrate was set at 3 cm. In the mixing region of $SiH_4$ gas and $F_2$ gas, blueish white luminescence was strongly observed.

In the case of the n-type amorphous silicon layer 203, $SiH_4$ gas filled in the bomb 101 was introduced at a flow rate of 20 sccm through the gas introducing pipe 109, $PH_3$/He gas filled in the bomb 104 ($PH_3$ concentration 1000 ppm) at a flow rate of 3 sccm through the gas introducing pipe 110, $F_2$ gas filled in the bomb 106 at a flow rate of 15 sccm and He gas filled in the bomb 107 at a flow rate of 80 sccm through the gas introducing pipe 111 into the vacuum chamber 120. The pressure in the vacuum chamber 120 was adjusted to 53.3 Pa (0.4 Torr) by controlling the opening of the vacuum valve 119.

In formation of the respective layers, the substrate temperature was set at 250 °C.

The solar battery thus obtained exhibited photoelectric converting efficiency higher by 20 % than the prior art produce.

Example 2

Fig. 3 illustrates schematically an example of the image forming member for electrophotography produced according to the present invention.

In this figure, on an Al substrate 300, a light reflection preventing layer 301 (first layer, amorphous silicon germanium layer controlled in band gap by Ge, thickness 0.5 $\mu$m), a charge injection preventing layer 302 (second layer, amorphous silicon layer doped with B, thickness 0.5 $\mu$m), a photosensitive layer 303 (third layer, amorphous silicon layer, thickness 18 $\mu$m), a surface protective layer and light absorption increasing layer 304 (fourth layer, amorphous silicon carbide layer controlled in band gap by C, thickness 0.1 $\mu$m) were formed as a laminate.

The image forming member as described above was produced by use of the apparatus for forming a deposited film shown in Example 1 under the film forming conditions shown in Table 1.

The image forming member for electrophotography obtained by this Example was found to exhibit charging characteristics improved by 22 % or more, reduced in image defect number by about 10 % and also improved in sensitivity by 18 % or more as compared with the prior art product.

Table 1

| (Substrate temperature 250 °C) | | | | |
|---|---|---|---|---|
| Layer structure | Starting material | Flow rate (SCCM) | Deposition method | Pressure (Torr) Pa |
| First layer a-SiGe | $SiH_4$ | 30 | Optical CVD | (0.3) 40 |
| | $B_2H_6$/He (1000 ppm) | 3.5 | | |
| | $GeH_4$ | 5 | | |
| | He | 20 | | |
| Second layer p-type | $SiH_4$ | 20 | Optical CVD | (0.3) 40 |
| | $B_2H_6$/He (1000 ppm) | 4 | | |
| | $N_2O$ | 8 | | |
| | He | 25 | | |
| Third layer i-type | $SiH_4$ | 80 | FOCVD | (0.8) 106.7 |
| | $F_2$ | 60 | | |
| | He | 200 | | |
| Fourth layer a-SiC | $SiH_4$ | 10 | FOCVD | (0.5) 66.7 |
| | $C_2H_4$ | 50 | | |
| | $F_2$ | 50 | | |
| | He | 50 | | |

Example 3

Fig. 4 illustrates schematically an example of TFT of the present invention.

In this figure, on a glass substrate 400, an amorphous silicon layer 401 (first layer, thickness 700 nm, 7000 Å), an amorphous silicon layer 402 doped with phosphorus to a high concentration (second layer, thickness 50 nm, 500 Å), an insulating layer 403 (third layer), thickness 100 nm, 1000 Å), and a gate electrode 404, source and drain electrodes 405, 405' of Al were formed.

The TFT as described above was prepared by use of the apparatus for forming a deposited film shown in Example 1 under the film conditions shown in Table 2.

The TFT prepared by this Example was improved in ON/OFF resistance ratio by about 15 % as compared with the prior art product.

Table 2

| (Substrate temperature 300 °C) | | | | |
|---|---|---|---|---|
| Layer structure | Starting material | Flow rate (SCCM) | Deposition method | Pressure (Torr) |
| First layer | $SiH_4$ | 20 | FOCVD | (0.7) 93.3 |
| | $F_2$ | 15 | | |
| | He | 150 | | |
| Second layer | $SiH_4$ | 15 | FOCVD | (0.6) 80 |
| | $PH_3$/He (1000 ppm) | 3 | | |
| | $F_2$ | 15 | | |
| | He | 20 | | |
| Third layer | $SiH_4$ | 20 | optical CVD | (0.3) 40 |
| | $C_2H_4$ | 100 | | |
| | He | 300 | | |

As described in detail above, since the respective layer are improved in interface characteristics, semiconductor devices with excellent characteristics can be obtained as shown by the above examples.

Also, the present invention can effect conservation of energy and at the same time can give an electronic device having a deposited film having uniform physical characteristics over a large area with easy management of the film quality. Further, it can give easily an electronic device having a multi-layer structure excellent in physical characteristics such as electrical, optical, semiconductor characteristics, etc., and in productivity and bulk productivity.

**Claims**

1. A method for producing a multi-layer structure comprising two or more semiconductor layers one at least of which is a thin layer controlled in band gap, formed on a substrate, which comprises:

   a) forming at least one of said semiconductor thin layers controlled in band gap according to optical CVD by bringing together a gaseous starting material and a material for controlling band gap; and

   b) forming at least one of other constituent layers, optionally controlled in band gap, according to a method comprising:

   i) introducing a gaseous starting material for formation of a deposited film and a gaseous halogenic oxidizing agent having the property of oxidizing said starting material into a reaction space to effect chemical contact therebetween to thereby form a plural number of precursors containing a precursor under excited state; and

   ii) transferring at least one precursor of those precursors into a film forming space communicated with the reaction space as a feeding source for the constituent element of the deposited film.

2. A method according to claim 1, wherein said semiconductor thin layer controlled in band gap is a group IV A element-containing deposited film.

3. A method according to claim 1, wherein said gaseous starting material is a chain silane compound.

4. A method according to claim 3, wherein said chain silane compound is a straight chain silane compound.

5. A method according to claim 4, wherein said straight chain silane compound is represented by the formula $Si_nH_{2n+2}$ (n is an integer of 1 to 8).

6. A method according to claim 3, wherein said chain silane compound is a branched chain silane compound.

**7.** A method according to claim 1, wherein said gaseous starting material is a silane compound having a cyclic structure of silicon.

**8.** A method according to claim 1, wherein said gaseous starting material is a chain germane compound.

**9.** A method according to claim 8, wherein said chain germanium compound is represented by the formula $Ge_mH_{2m+2}$ (m is an integer of 1 to 5).

**10.** A method according to claim 1, wherein said gaseous starting material is a group IV A element-containing compound.

**11.** A method according to claim 1, wherein said gaseous halogenic oxidizing agent contains a halogen gas.

**12.** A method according to claim 1, wherein said gaseous halogenic oxidizing agent contains fluorine gas.

**13.** A method according to claim 1, wherein said gaseous halogenic oxidizing agent contains chlorine gas.

**14.** A method according to claim 1, wherein said gaseous halogenic oxidizing agent is a gas containing fluorine atoms as a constituent.

**15.** A method according to claim 1, wherein said gaseous halogenic oxidizing agent contains a halogen under nascent state.

**16.** A method according to claim 1, wherein said substrate is arranged at a position opposed to the direction in which said gaseous starting material and said gaseous halogenic oxidizing agent are introduced into said reaction space.

**17.** A method according to claim 1, wherein a gaseous material for supplying a band gap controller is introduced into said reaction space.

**18.** A method according to claim 17, wherein said gaseous material is selected from carbon containing compounds, oxygen containing compounds and nitrogen containing compounds.

**19.** A method according to claim 18, wherein said selected gaseous material is one selected from the group consisting of $CH_4$, $C_2H_6$, $C_3H_8$, $C_4H_{10}$, $C_2H_4$, $C_3H_6$, $C_4H_8$, $C_2H_2$, $C_6H_6$, $O_2$, $CO_2$, NO, $NO_2$, $N_2O$, $O_3$, CO, $H_2O$, $CH_3OH$, $CH_3CH_2OH$, $N_2$, $NH_3$, $N_2H_5N_3$, $N_2H_4$ and $NH_4N_3$.

**20.** A method according to claim 1, wherein a gaseous material for supplying a valence electron controller is introduced into said reaction space.

**Patentansprüche**

**1.** Verfahren zur Herstellung einer auf einem Substrat gebildeten Mehrschichtenstruktur mit zwei oder mehr Halbleiterschichten, von denen mindestens eine eine Dünnschicht mit gesteuertem Bandabstand ist, bei dem:
   a) mindestens eine der Halbleiterdünnschichten mit gesteuertem Bandabstand gemäß dem optischen CVD-Verfahren gebildet wird, indem ein gasförmiges Ausgangsmaterial und ein Material für die Steuerung des Bandabstands zusammengebracht werden, und
   b) mindestens eine der anderen einen Bestandteil bildenden Schichten, wahlweise mit gesteuertem Bandabstand, gemäß einem Verfahren gebildet wird, bei dem
      i) ein gasförmiges Ausgangsmaterial für die Bildung eines abgeschiedenen Films und ein gasförmiges halogenisches Oxidationsmittel, das die Eigenschaft hat, daß es das Ausgangsmaterial oxidiert, in einen Reaktionsraum eingeführt werden, um dazwischen einen chemischen Kontakt zu bewirken und dadurch eine Vielzahl von Vorläufern zu bilden, die einen Vorläufer in angeregtem Zustand enthalten, und
      ii) mindestens ein Vorläufer von diesen Vorläufern als Zuführungsquelle für das Element, das Bestandteil des abgeschiedenen Films ist, in einen Filmbildungsraum überführt wird, der mit dem Reaktionsraum in Verbindung steht.

2. Verfahren nach Anspruch 1, bei dem die Halbleiterdünnschicht mit gesteuertem Bandabstand ein abgeschiedener Film ist, der ein Element der Gruppe IV A enthält.

3. Verfahren nach Anspruch 1, bei dem das gasförmige Ausgangsmaterial eine Silan-Kettenverbindung ist.

4. Verfahren nach Anspruch 3, bei dem die Silan-Kettenverbindung eine geradkettige Silanverbindung ist.

5. Verfahren nach Anspruch 4, bei dem die geradkettige Silanverbindung durch die Formel $Si_nH_{2n+2}$ - (worin n eine ganze Zahl von 1 bis 8 ist) wiedergegeben wird.

6. Verfahren nach Anspruch 3, bei dem die Silan-Kettenverbindung eine verzweigtkettige Silanverbindung ist.

7. Verfahren nach Anspruch 1, bei dem das gasförmige Ausgangsmaterial eine Silanverbindung mit einer cyclischen Siliciumstruktur ist.

8. Verfahren nach Anspruch 1, bei dem das gasförmige Ausgangsmaterial eine German-Kettenverbindung ist.

9. Verfahren nach Anspruch 8, bei dem die Germanium-Kettenverbindung durch die Formel $Ge_mH_{2m+2}$ - (worin m eine ganze Zahl von 1 bis 5 ist) wiedergegeben wird.

10. Verfahren nach Anspruch 1, bei dem das gasförmige Ausgangsmaterial eine Verbindung ist, die ein Element der Gruppe IV A enthält.

11. Verfahren nach Anspruch 1, bei dem das gasförmige halogenische Oxidationsmittel ein Halogengas enthält.

12. Verfahren nach Anspruch 1, bei dem das gasförmige halogenische Oxidationsmittel Fluorgas enthält.

13. Verfahren nach Anspruch 1, bei dem das gasförmige halogenische Oxidationsmittel Chlorgas enthält.

14. Verfahren nach Anspruch 1, bei dem das gasförmige halogenische Oxidationsmittel ein Gas ist, das Fluoratome als Bestandteil enthält.

15. Verfahren nach Anspruch 1, bei dem das gasförmige halogenische Oxidationsmittel ein Halogen in statu nascendi enthält.

16. Verfahren nach Anspruch 1, bei dem das Substrat an einer Stelle angeordnet ist, die der Richtung, in der das gasförmige Ausgangsmaterial und das gasförmige halogenische Oxidationsmittel in den Reaktionsraum eingeführt werden, gegenüberliegt.

17. Verfahren nach Anspruch 1, bei dem in den Reaktionsraum ein gasförmiges Material für die Zuführung eines Mittels zur Steuerung des Bandabstandes eingeführt wird.

18. Verfahren nach Anspruch 17, bei dem das gasförmige Material aus kohlenstoffhaltigen Verbindungen, sauerstoffhaltigen Verbindungen und stickstoffstoffhaltigen Verbindungen ausgewählt ist.

19. Verfahren nach Anspruch 18, bei dem das ausgewählte gasförmige Material eines ist, das aus der Gruppe ausgewählt ist, die aus $CH_4$, $C_2H_6$, $C_3H_8$, $C_4H_{10}$, $C_2H_4$, $C_3H_6$, $C_4H_8$, $C_2H_2$, $C_6H_6$, $O_2$, $CO_2$, $NO$, $NO_2$, $N_2O$, $O_3$, $CO$, $H_2O$, $CH_3OH$, $CH_3CH_2OH$, $N_2$, $NH_3$, $N_2H_5N_3$, $N_2H_4$ und $NH_4N_3$ besteht.

20. Verfahren nach Anspruch 1, bei dem in den Reaktionsraum ein gasförmiges Material für die Zuführung eines Mittels zur Steuerung der Valenzelektronen eingeführt wird.

**Revendications**

**1.** Procédé de production d'une structure multicouche comprenant deux ou plus de deux couches à semiconducteurs dont l'une au moins est une couche mince réglée dans la bande interdite, formée sur un substrat, procédé qui consiste :

    a) à former au moins l'une desdites couches minces à semiconducteurs réglées dans la bande interdite conformément au procédé optique CVD par réunion d'une matière gazeuse de départ et d'une matière servant au réglage de la bande interdite ; et

    b) à former au moins l'une des autres couches constitutives, facultativement réglées dans la bande interdite, conformément à un procédé comprenant :

        i) l'introduction d'une matière gazeuse de départ pour la formation d'un film déposé et d'un agent oxydant halogéné gazeux ayant la propriété d'oxyder ladite matière de départ dans un espace de réaction pour créer un contact chimique entre eux de manière à former une pluralité de précurseurs contenant un précurseur dans un état excité ; et

        ii) le transfert d'au moins l'un de ses précurseurs dans un espace de formation d'un film en communication avec l'espace de réaction comme source d'alimentation en élément constitutif du film déposé.

**2.** Procédé suivant la revendication 1, dans lequel la mince couche à semiconducteur réglée dans la bande interdite est un film déposé contenant un élément du Groupe IV A.

**3.** Procédé suivant la revendication 1, dans lequel ladite matière gazeuse de départ est un silane en chaîne.

**4.** Procédé suivant la revendication 3, dans lequel le silane en chaîne est un silane en chaîne droite.

**5.** Procédé suivant la revendication 4, dans lequel le silane en chaîne droite est représenté par la formule $Si_nH_{2n+2}$ (n est un nombre entier de 1 à 8).

**6.** Procédé suivant la revendication 3, dans lequel le silane en chaîne est un silane en chaîne ramifiée.

**7.** Procédé suivant la revendication 1, dans lequel la matière gazeuse de départ est un silane ayant une structure cyclique de silicium.

**8.** Procédé suivant la revendication 1, dans lequel la matière gazeuse de départ est un germane en chaîne.

**9.** Procédé suivant la revendication 8, dans lequel le composé le germanium en chaîne est représenté par la formule $Ge_mH_{2m+2}$ (m est un nombre entier de 1 à 5).

**10.** Procédé suivant la revendication 1, dans lequel la matière gazeuse de départ est un composé contenant un élément du Groupe IV A.

**11.** Procédé suivant la revendication 1, dans lequel l'agent oxydant halogéné gazeux contient un halogène gazeux.

**12.** Procédé suivant la revendication 1, dans lequel l'agent oxydant halogéné gazeux contient du fluor gazeux.

**13.** Procédé suivant la revendication 1, dans lequel l'agent oxydant halogéné gazeux contient du chlore gazeux.

**14.** Procédé suivant la revendication 1, dans lequel l'agent oxydant halogéné gazeux est un gaz contenant des atomes de fluor comme constituant.

**15.** Procédé suivant la revendication 1, dans lequel l'agent oxydant halogéné gazeux contient un halogène à l'état naissant.

**16.** Procédé suivant la revendication 1, dans lequel le substrat occupe une position opposée à la direction dans laquelle la matière gazeuse de départ et l'agent oxydant halogéné gazeux sont introduits dans l'espace de réaction.

17. Procédé suivant la revendication 1, dans lequel une matière gazeuse fournissant un régulateur de bande interdite est introduit dans l'espace de réaction.

18. Procédé suivant la revendication 17, dans lequel la matière gazeuse est choisie entre des composés contenant du carbone, des composés contenant de l'oxygène et des composés contenant de l'azote.

19. Procédé suivant la revendication 18, dans lequel la matière gazeuse choisie est une matière choisie dans le groupe comprenant $CH_4$, $C_2H_6$, $C_3H_8$, $C_4H_{10}$, $C_2H_4$, $C_3H_6$, $C_4H_8$, $C_2H_2$, $C_6H_6$, $O_2$, $CO_2$, NO, $NO_2$, $N_2O$, $O_3$, CO, $H_2O$, $CH_3OH$, $CH_3CH_2OH$, $N_2$, $NH_3$, $N_2H_5N_3$, $N_2H_4$ et $NH_4N_3$.

20. Procédé suivant la revendication 1, dans lequel une matière gazeuse fournissant un régulateur d'électrons de valence est introduite dans l'espace de réaction.

# FIG. 1

## FIG. 2

- 204
- 203
- 202
- 201
- 200

## FIG. 3

- 304
- 303
- 302
- 301
- 300

## FIG. 4

- 405
- 404
- 405'
- 402
- 403
- 401
- 400

FIG. 5